**Europäisches Patentamt**

**European Patent Office**

**Office européen des brevets**

(19)

(11) Veröffentlichungsnummer: **0 032 530**
**A1**

(12) **EUROPÄISCHE PATENTANMELDUNG**

(21) Anmeldenummer: 80106758.8

(22) Anmeldetag: 04.11.80

(51) Int. Cl.³: **C 23 G 3/00**, C 23 F 1/08,
C 25 D 17/02, C 25 F 7/00

(30) Priorität: 18.01.80 DE 3001726

(43) Veröffentlichungstag der Anmeldung: 29.07.81
Patentblatt 81/30

(84) Benannte Vertragsstaaten: BE CH FR GB IT LI NL

(71) Anmelder: **Gebr. Schmid GmbH & Co.,**
**Robert-Bosch-Strasse 34, D-7290 Freudenstadt (DE)**

(72) Erfinder: **Schmid, Dieter, Am Schäferstich 19,**
**D-7290 Freudenstadt (DE)**

(74) Vertreter: **Hoeger, Stellrecht & Partner,**
**Uhlandstrasse 14c, D-7000 Stuttgart 1 (DE)**

(54) **Verwendung einer Vorrichtung zum Behandeln eines plattenförmigen Gegenstandes mittels einer Flüssigkeit.**

(57) Zur Behandlung von plattenförmigen Gegenständen (21) mit einer Flüssigkeit (7, 10) wird die Verwendung einer Vorrichtung mit einem ersten Behälter (6) zur Aufnahme einer Flüssigkeit (7) (ausgenommen flüssiges Lötmittel), mit einem zweiten Behälter (9), der in zwei gegenüberliegenden Wänden (22, 23) horizontal verlaufende, schlitzförmige Öffnungen (35) aufweist, die in der Vorschubebene von horizontal vorgeschobenen plattenförmigen Gegenständen (21) liegen, und mit einer Pumpe (37), die die Flüssigkeit in solcher Menge aus dem ersten Behälter (6) in den zweiten Behälter (9) pumpt, daß das Flüssigkeitsniveau (38) im zweiten Behälter (9) oberhalb der Öffnungen liegt, vorgeschlagen.

EP 0 032 530 A1

COMPLETE DOCUMENT

Anmelder: Gebr. Schmid GmbH & Co.
Robert-Bosch-Straße 34
D-7290 Freudenstadt

- 3 -

B e s c h r e i b u n g

Verwendung einer Vorrichtung zum Behandeln eines plattenförmigen Gegenstandes
mittels einer Flüssigkeit

In der auf dieselbe Anmelderin zurückgehenden älteren Patentanmeldung P 28 56 460.5 ist eine Vorrichtung zum Aufbringen einer
metallischen Lötmittelschicht auf eine Leiterplatte durch
Kontakt der Leiterplatte mit dem flüssigen Lötmittel vorgeschlagen worden. Diese Vorrichtung ist gekennzeichnet durch
einen ersten Behälter zur Aufnahme des flüssigen Lötmittels,
durch einen zweiten Behälter, der in zwei gegenüberliegenden
Wänden horizontal verlaufende, schlitzförmige Öffnungen aufweist, die in der Vorschubebene der horizontalen vorgeschobenen Leiterplatten liegen, und durch eine Pumpe, die das flüssige Lötmittel in solcher Menge aus dem ersten Behälter in den
zweiten Behälter pumpt, daß das Lötmittelniveau im zweiten Behälter oberhalb der Öffnungen liegt.

Der Erfindung liegt die Aufgabe zugrunde, eine Möglichkeit anzugeben, wie plattenförmige Gegenstände mit einer Flüssigkeit
behandelt werden können.

Diese Aufgabe wird gemäß der Erfindung gelöst durch die Verwendung einer Vorrichtung mit einem ersten Behälter zur Aufnahme einer Flüssigkeit (ausgenommen flüssiges Lötmittel),
mit einem zweiten Behälter, der in zwei gegenüberliegenden Wänden horizontal verlaufende, schlitzförmige Öffnungen aufweist,
die in der Vorschubebene des horizontal vorgeschobenen plattenförmigen Gegenstandes liegen, und mit einer Pumpe, die die
Flüssigkeit in solchen Mengen aus dem ersten Behälter in den
zweiten Behälter pumpt, daß das Flüssigkeitsniveau im zweiten
Behälter oberhalb der Öffnungen liegt, zur Behandlung von
plattenförmigen, horizontal vorgeschobenen Gegenständen mit
dieser Flüssigkeit.

Die mit dieser Vorrichtung mögliche Behandlung kann beispielsweise die Entfernung von Material von den plattenförmigen
Gegenständen sein.

Bei einer bevorzugten Verwendung ist die Flüssigkeit ein
Reinigungs-, Ätz- oder Entfettungsbad., bzw. ein Oxidationsmittel.

Bei einer anderen bevorzugten Verwendung ist die Flüssigkeit
ein Elektrolyt, wobei die Materialentfernung elektrolytisch
erfolgt.

Bei einer weiteren bevorzugten Verwendung ist die Flüssigkeit
ein Lösungsmittel.

Die Vorrichtung kann gemäß der Erfindung auch zur Ablagerung
von Material (ausgenommen Lötmittel) auf plattenförmigen Gegenständen Verwendung finden. Dabei ist besonders günstig, wenn
die Flüssigkeit ein Elektrolyt ist und die Materialablagerung
elektrolytisch erfolgt.

Für die elektrolytische Materialentfernung oder -ablagerung
ist besonders geeignet eine Vorrichtung der oben beschriebenen Art mit einlaufseitigen Abstreifelementen aus einem
elektrisch leitenden Material, die eine Elektrode bilden, während eine Gegenelektrode in dem zweiten Behälter unterhalb des Flüssigkeitsniveaus angeordnet ist.

Insbesondere bei der Verwendung einer solchen Vorrichtung zur Materialentfernung erweist es sich als günstig, wenn oberhalb und/oder unterhalb der Vorschubebene des plattenförmigen Gegenstandes zumindest teilweise in die Flüssigkeit im zweiten Behälter eintauchende Ultraschallerzeuger angeordnet sind, die derart gerichtet sind, daß im Bereich der Vorschubebene ein Ultraschallfeld entsteht.

Vorteilhaft ist es weiterhin, wenn der zweite Behälter oberhalb des ersten Behälters angeordnet ist, so daß aus dem zweiten Behälter ausfließende Flüssigkeit im ersten Behälter gesammelt wird.

Bei einer bevorzugten Ausführungsform der erfindungsgemäß verwendeten Vorrichtung ist vorgesehen, daß auf der Ober- und auf der Unterseite der schlitzförmigen Öffnungen je ein Abstreifelement angeordnet ist.

Vorzugsweise ist das obere Abstreifelement in senkrechter Richtung derart verschieblich gelagert, daß es bei in die Öffnung eingeschobenem Gegenstand auf diesem aufliegt und bei fehlendem Gegenstand auf dem unteren Abstreifelement, so daß die Öffnung im wesentlichen verschlossen ist.

Die Abstreifelemente können gemäß einer bevorzugten Ausführungsform der erfindungsgemäß verwendeten Vorrichtung Walzen sein. Dabei ist es günstig, wenn mindestens eine der Walzen jedes Walzenpaares angetrieben ist.

Insbesondere kann vorgesehen sein, daß die Abstreifelemente derart angeordnet sind, daß sie einen Teil der Seitenwand bilden und die schlitzförmige Öffnung zwischen sich ausbilden.

Die nachfolgende Beschreibung bevorzugt Verwendung findender Vorrichtungen dient im Zusammenhang mit der Zeichnung der näheren Erläuterung. Es zeigen:

Fig. 1 eine Längsschnittansicht einer erfindungsgemäß verwendeten Behandlungsvorrichtung;

Fig. 2 eine Querschnittansicht der in Fig. 1 dargestellten Behandlungsvorrichtung;

Fig. 3 eine Ansicht ähnlich Fig. 1 einer abgewandelten Vorrichtung für elektrolytische Behandlung und

Fig. 4 eine Ansicht ähnlich Fig. 3 einer abgewandelten Behandlungsvorrichtung für die Materialentfernung mit Ultraschallerzeugern.

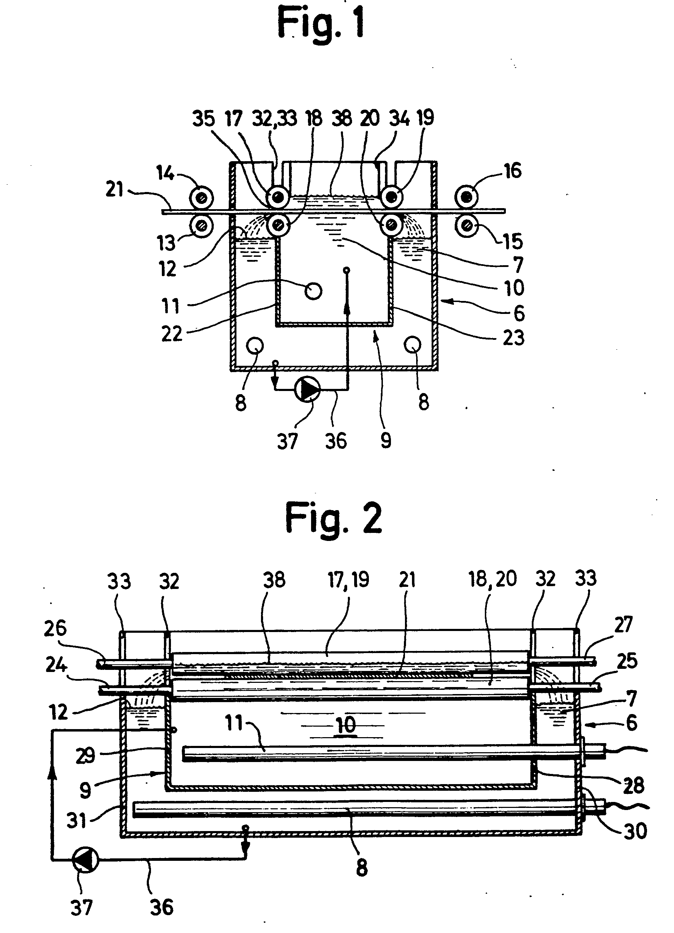

Aus den Figuren 1 und 2, die den Aufbau der Behandlungsvorrichtungen relativ schematisch wiedergeben, erkennt man einen äußeren Behälter 6, in dem sich eine Flüssigkeit 7 befindet. Durch eine Heizung 8 kann die Flüssigkeit auf einer gewünschten Temperatur gehalten werden.

In dem äußeren Behälter 6 befindet sich ein weiterer Behälter 9, der ebenfalls mit Flüssigkeit 10 gefüllt ist, welche mittels einer Heizung 11 auf der notwendigen Temperatur gehalten werden kann. Der Behälter 9 kann - wie in den Figuren 1 und 2 gezeigt - in die Flüssigkeit 7 eintauchen, er kann sich auch

- 7 -

oberhalb des Flüssigkeitsniveaus 12 im Behälter 6 befinden,
wobei die Anordnung der Figuren 1 und 2 aus Gründen einer
niedrigeren Bauhöhe vorteilhaft ist.

Am Maschinengestell gelagerte, paarweise angeordnete Walzen
13 bis 20 dienen als Vorschubstrecke für die zu behandelnden,
plattenförmigen Gegenstände 21. Vorzugsweise ist jeweils mindestens eine Walze jedes Walzenpaares angetrieben.

Die Walzen 17, 18, 19 und 20 sind derart gelagert, daß sich
ihre Achsen in der Verlängerung der Vorderwand 22 bzw. der
Rückwand 23 des Behälters 9 befinden. Die unteren Walzen 18
und 20 laufen dabei dicht an der oberen Kante des Behälters 6
und sind mittels Wellenstücken 24, 25 in nicht dargestellter
Weise drehbar am Maschinengestell gelagert. In ähnlicher Weise sind die oberen Walzen 17 und 19 mittels Wellenstücken 26
und 27 am Maschinengestell drehbar gelagert, jedoch sind diese oberen Walzen zusätzlich in senkrechter Richtung verschieblich, so daß der gegenseitige Abstand der Walzen 17 und 18
sowie der Walzen 19 und 20 veränderbar ist. Die Seitenwände
28 und 29 des inneren Behälters 9 sowie die Seitenwände 30 und
31 des äußeren Behälters 6 weisen entsprechende schlitzförmige
Ausnehmungen 32 bzw. 33 auf, durch welche die Wellenstücke 24
bis 27 hindurchtreten.

In mindestens einer der Seitenwände 28, 29 des inneren Behälters 9 befindet sich im Bereich zwischen den Walzenausnehmungen 32 eine weitere Ausnehmung 34, die einen Überlauf für den
inneren Behälter 9 bildet. Der untere Rand dieser Ausnehmung
34 befindet sich oberhalb der schlitzförmigen Öffnungen 35,
die die Walzen 17 und 18 bzw. 19 und 20 zwischen sich ausbilden, vorzugsweise auf der Höhe der Wellenstücke 26 und 27 der oberen Walzen 17 und 19.

Der Behälter 6 ist über eine Pumpleitung 36, in die eine Pumpe
37 eingeschaltet ist, mit dem Behälter 9 verbunden.

Zur Behandlung eines plattenförmigen Gegenstandes 21 mit Flüssigkeit wird dieser mittels der Walzen 13 bis 20 horizontal
vorgeschoben. Solange die Vorderkante des Gegenstandes 21 sich
noch nicht zwischen den Walzen 17 und 18 befindet, liegen die
in senkrechter Richtung verschieblichen oberen Walzen 17 und
19 unter dem Einfluß der Schwerkraft an den ihnen gegenüberliegenden unteren Walzen 18 bzw. 20 an und verschließen so
die schlitzförmigen Öffnungen 35. In diesem Zustand ist der
Behälter 9 im Bereich der Seitenwände bis zur Höhe der Unterkante der Ausnehmung 34 weitgehend abgedichtet.

Mittels der Pumpe 37 wird laufend Flüssigkeit aus dem Behälter
6 in den Behälter 9 gepumpt, so daß sich im Behälter 9 ein
durch die Ausnehmung 34 definierter Flüssigkeitsspiegel 38
einstellt. Verluste, die dadurch entstehen, daß die Flüssigkeit im Bereich der Vorderwand und der Rückwand unterhalb der
Walzen 18 und 20 und seitlich der Walzen 17 bis 20 sowie im
Bereich der Seitenwände an den Ausnehmungen 32 aus dem Behälter 9 ausfließt, werden durch eine entsprechend hohe Leistung
der Pumpe 37 ausgeglichen.

Beim Vorschieben der Gegenstände 21 treten diese mit ihrem
vorderen Rand in die schlitzförmige Öffnung 37 zwischen den
Walzen 17 und 18 ein und verschieben dabei die obere Walze 17
entgegen der Schwerkraft nach oben, so daß die Walzen 17 und
18 auf der Vorder- und auf der Rückseite der Gegenstände 21
abrollen. In gleicher Weise erfolgt eine Trennung der Walzen 19 und 20 beim weiteren Vorschieben der Gegenstände. Auf diese
Weise werden die gesamten Gegenstände durch den Behälter 9 hindurchgeschoben, wobei sich die Gegenstände immer unterhalb des
Flüssigkeitsspiegels 38 befinden. Das wird dadurch gewährleistet, daß die Leistung der Pumpe 3 hoch genug gewählt wird,
um alle Flüssigkeitsverluste des Behälters 9 zu kompensieren,
auch die Verluste, die sich gegebenenfalls durch einen Verbrauch der Flüssigkeit ergeben.

Insbesondere die Walzen am Austrittsende des Behälters 9 wirken gleichzeitig als Abstreifelemente, die überschüssige Flüssigkeit von den Gegenständen abstreifen und im Behälter 9 zurückhalten. Gegebenenfalls ist es möglich, die oberen Walzen
17 und 19 nach unten vorzuspannen, beispielsweise mittels Federn oder Zusatzgewichten, so daß die Auflagekraft und damit
die Abstreifwirkung dieser oberen Walzen erhöht werden.

Die aus dem Behälter 9 ausströmende Flüssigkeit wird im Behälter 6 aufgefangen, so daß sich ein Flüssigkeitskreislauf ergibt.

Die vorstehend beschriebene Vorrichtung ist besonders vorteilhaft im Betrieb, da die schlitzförmigen Öffnungen 35 durch
diese Öffnungen automatisch verschließende, gleichzeitig als
Abstreifelemente und als Teil der Vorschubstrecke wirkende
Walzen gebildet werden. Bei anderen, in der Zeichnung nicht
dargestellten Ausführungsformen könnten statt der Walzen 17,
18, 19 und 20 auch feststehende Abstreifelemente verwendet werden. Weiterhin ist es bei bestimmten Anwendungen möglich, auf
diese Elemente ganz zu verzichten und in der Vorder- und in
der Rückwand des Behälters 9 lediglich je einen horizontalen
Schlitz vorzusehen. Da dann die Flüssigkeitsverluste bei fehlendem Gegenstand höher wären, müßte die Pumpleistung entsprechend gesteigert werden, damit der Flüssigkeitsspiegel 38 im Behälter 9 in jedem Falle oberhalb der schlitzförmigen Öffnung 35 steht.

Abstreifelemente, insbesondere Walzenpaare, können auch in Vorschubrichtung der Gegenstände gesehen unmittelbar vor oder unmittelbar hinter den schlitzförmigen Öffnungen 35 angeordnet werden, so daß sie nur die Abstreif- und evtl. Vorschubaufgabe übernehmen, nicht jedoch die Aufgabe der Bildung der schlitzförmigen Öffnungen 35, die in diesem Falle in der Vorder- oder Rückwand selbst anzuordnen wären.

Bei der beschriebenen Vorrichtung können die Gegenstände durch die gesamte Vorrichtung in horizontaler Lage kontinuierlich hindurfhgeführt werden, ohne daß zur Behandlung mit der Flüssigkeit eine Schwenkung oder eine andere Lageveränderung notwendig ist. Dadurch kann der gesamte Vorgang vollständig automatisiert und dadurch erheblich vereinfacht oder beschleunigt werden, wobei sich ausgezeichnete und vollständig reproduzierbare Behandlungsergebnisse erzielen lassen.

Die beschriebene Vorrichtung läßt sich auf verschiedene Weise zur Behandlung von plattenförmigen Gegenständen verwenden. Beispielsweise kann die Behandlung in einer Reinigung, einer Entfettung, einer Oxydation oder einem Ätzvorgang bestehen. Die Flüssigkeit können dann beispielsweise saure Entfettungsmittel wie Phosphorsäure, Salpetersäure, Thioharnstoff oder Mischungen dieser Substanzen, Schwefelsäure, Wasserstoffperoxid und Mischungen dieser Substanzen, Ammoniumpersulfat, Natriumsulfat evtl. zusammen mit Schwefelsäure, Netzmittel oder bekannte alkalische oder saure Ätzmittel sein, bzw. Oxydierende Flüssigkeiten wie $NaClo_2$ und ähnliche Substanzen.

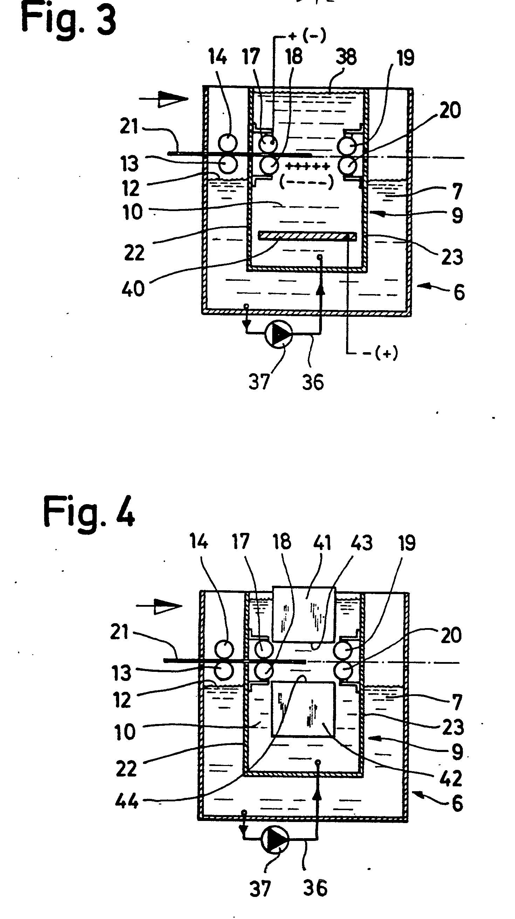

Es ist auch möglich, die beschriebene Vorrichtung zur galvanischen Behandlung der vorgeschobenen plattenförmigen Gegenstände zu verwenden. Dazu ist besonders günstig die in Fig. 2 dargestellte Abwandlung der Vorrichtung. Bei dieser Vorrichtung sind die einlaufseitigen Abstreiferwalzen 17 und 18, die im dargestellten Ausführungsbeispiel in Vorschubrichtung hinter dem Einlaufschlitz liegen, aus elektrisch leitendem Material hergestellt und bilden eine Elektrode. Eine zweite Elektrode 40 befindet sich in der Flüssigkeit 10 des Behälters 9. Im übrigen ist die Vorrichtung weitgehend gleich aufgebaut wie die in den Figuren 2 und 3 dargestellte, entsprechende Teile tragen daher gleiche Bezugszeichen.

Je nach Polung der beiden Elektroden und je nach Verwendung der Elektrolyten kann auf diese Weise Material elektrolytisch von den Gegenständen entfernt oder elektrolytisch auf diese aufgebracht werden. Beispielsweise kann zur elektrolytischen Materialentfernung ein Elektrolyt einer Schwefelsäurelösung mit Zusatz von Wasserstoffperoxid verwendet werden. Die Einlaufwalzen können beispielsweise aus Titan, Wolfram oder Graphit bestehen.

Bei einer weiteren bevorzugten Verwendung werden Materialien von den vorgeschobenen Gegenständen entfernt, beispielsweise werden Photopolymere auf Leiterplatten durch geeignete Lösungsmittel von den Leiterplatten entfernt, nachdem sie belichtet worden sind. Dazu können herkömmliche Lösungsmittel verwendet werden oder Laugen, die in die zu entfernenden Schichten eindiffundieren und diese von der Unterlage abheben. Dabei ist eine Ausgestaltung der Vorrichtung besonders vorteilhaft, wie sie in Fig. 4 dargestellt ist. Das dort dargestellte Ausführungsbeispiel gleicht weitgehend dem der Fig. 3, gleiche Tei-

- 12 -

le tragen daher gleiche Bezugszeichen.

Oberhalb und unterhalb der Vorschubebene tauchen in die Flüssigkeit 10 Ultraschallgeber 41, 42 ein, die mit ihren aktiven Flächen 43 bzw. 44 der Vorschubebene derart zugewandt sind, daß sie im Bereich der Vorschubebene ein Ultraschallfeld erzeugen. Dieses Ultraschallfeld unterstützt die Entfernung von Material von den Gegenständen unter dem Einfluß der im Behälter 9 befindlichen Behandlungsflüssigkeit.

Die Ultraschallgeber können beispielsweise piezorestriktive Kristalle oder Quarze sein.

Die beschriebenen Vorrichtungen eignen sich zur vollautomatischen Behandlung horizontal vorgeschobener Platten. In Fertigungsstraßen können mehrere derartige Vorrichtungen hintereinandergeschaltet werden, in denen die vorgeschobenen Platten mit unterschiedlichen Flüssigkeiten behandelt werden. Beispielsweise ist bei einer Fertigungsstraße zur Herstellung von Leiterplatten möglich, die Leiterplatten in einer ersten Station mit einem Flußmittel in Kontakt zu bringen, in einer zweiten Station mit einem flüssigen Lötmittel und in einer dritten Station mit einem Reinigungsmittel. Der gesamte Herstellungsablauf kann dabei in einfachster Weise und vollautomatisch durchgeführt werden.

0032530

Anmelder: Gebr. Schmid GmbH & Co.
Robert-Bosch-Straße 34
D-7290 Freudenstadt

Patentansprüche:

1. Verwendung einer Vorrichtung mit einem ersten Behälter zur
Aufnahme einer Flüssigkeit (ausgenommen flüssiges Lötmittel), mit einem zweiten Behälter, der in zwei gegenüberliegenden Wänden horizontal verlaufende, schlitzförmige Öffnungen aufweist, die in der Vorschubebene von horizontal
vorgeschobenen plattenförmigen Gegenständen liegen, und
mit einer Pumpe, die die Flüssigkeit in solcher Menge aus
dem ersten Behälter in den zweiten Behälter pumpt, daß das
Flüssigkeitsniveau im zweiten Behälter oberhalb der Öffnungen liegt, zur Behandlung von plattenförmigen, horizontal
vorgeschobenen Gegenständen mit der Flüssigkeit.

2. Verwendung nach Anspruch 1, dadurch gekennzeichnet, daß die
Behandlung eine Entfernung von Material von den plattenförmigen Gegenständen ist.

3. Verwendung nach Anspruch 2, dadurch gekennzeichnet, daß die
Flüssigkeit ein Reinigungs-, Ätz- oder Entfettungsbad ist,
bzw. eine oxidierende Flüssigkeit.

4. Verwendung nach Anspruch 2, dadurch gekennzeichnet, daß die
Flüssigkeit ein Lösungsmittel ist.

5. Verwendung nach Anspruch 1, dadurch gekennzeichnet, daß die Behandlung der Ablagerung von Material (ausgenommen Lötmittel) auf den plattenförmigen Gegenständen dient.

6. Verwendung nach einem der Ansprüche 2 oder 5, dadurch gekennzeichnet, daß die Flüssigkeit ein Elektrolyt ist und die Materialentfernung oder -ablagerung elektrolytisch erfolgt.

7. Vorrichtung zur Verwendung gemäß den Ansprüchen 2, 3 und 4, dadurch gekennzeichnet, daß oberhalb und/oder unterhalb der Vorschubebene des plattenförmigen Gegenstandes (21) zumindest teilweise in die Flüssigkeit (10) im zweiten Behälter (9) eintauchende Ultraschallerzeuger (41, 42) angeordnet sind, die derart gerichtet sind, daß im Bereich der Vorschubebene ein Ultraschallfeld entsteht.

8. Vorrichtung zur Verwendung gemäß Anspruch 6, dadurch gekennzeichnet, daß die einlaufseitigen Abstreifelemente (17, 18) aus einem elektrisch leitenden Material bestehen und eine Elektrode bilden, während eine Gegenelektrode (40) in dem zweiten Behälter (9) unterhalb des Flüssigkeitsniveaus (38) angeordnet ist.

-7/2-

## Fig. 1

## Fig. 2

0032530

-2/2-

Fig. 3

Fig. 4

0032530

Europäisches
Patentamt

**EUROPÄISCHER RECHERCHENBERICHT**

Nummer der Anmeldung

EP 80106758.8

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | DE - A - 1 771 934 (MÖHL UND CO. KG)  + Ansprüche; Fig. +  ---- | 1-3 |

**KLASSIFIKATION DER ANMELDUNG (Int. Cl.³)**

C 23 G   3/00
C 23 F   1/08
C 25 D  17/02
C 25 F   7/00

**RECHERCHIERTE SACHGEBIETE (Int. Cl.³)**

C 23 G
C 23 F
C 25 F
C 25 D

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 17-03-1981 | SLAMA |

EPA form 1503.1   06.78